# EUROPEAN PATENT APPLICATION

(11) **EP 4 502 243 A1**
(43) Date of publication of application: **05.02.2025**
(21) Application number: 23773993.3
(22) Date of filing: 24.03.2023
(51) Int. Cl.: C25D 5/02, C25D 17/00, H01L 31/02, C25D 19/00

(54) **CELL ELECTROPLATING METHOD AND APPARATUS**

(30) Priority: 25.03.2022 CN 202210307453; 29.07.2022 CN 202210909109
(71) Applicant: Suzhou Sunwell New Energy Co., Ltd., Suzhou, Jiangsu 215127 (CN)
(72) Inventor: YAO, Yu, Suzhou, Jiangsu 215127 (CN); LI, Zhongtian, Suzhou, Jiangsu 215127 (CN)
(74) Representative: Meissner Bolte Partnerschaft mbB
(86) International application number: PCT/CN2023/083583
(87) International publication number: WO 2023/179748

(57) **Abstract**

Disclosed are a cell electroplating method and apparatus, wherein: a flexible conductive piece is attached to a mask opening on a cell surface to be electroplated, so that the conductive piece forms a direct or indirect electrical connection with a conductive material layer of a cell exposed through the mask opening. The invention achieves the electroplating of a metal material of one or two surfaces of a cell via a mask opening, thereby avoiding the problems of cracking or fragmentation caused by hard conductive points clamping the cell.

## Description

### Technical Field

The present disclosure relates to the field of solar cells and semiconductor manufacturing, specifically to a method for electroplating a solar cell precursor, and an apparatus for implementing the method, which are used for simultaneously depositing metal electrodes on one or both surfaces of the solar cell precursor.

### Background

In order to further reduce cost of solar cells and improve photoelectric conversion efficiency, using copper electroplating instead of screen printing of silver paste to produce metal grid lines for solar cells attracts an increasing attention and is more researched. Under the trend of thinning of solar cells, the method using hard electrical conductor to clamp solar cells learning from the electroplating equipment in PCB or semiconductor industry is facing increasing challenges, imprinting or hidden cracks at the clamping position also have a negative impact on the appearance and power generation efficiency of solar cells to a certain extent. There are also some precedents for deriving horizontal electroplating equipment by learning and modifying the transmission method of horizontal texturing or etching equipment for cells.

One application of horizontal electroplating in the photovoltaic field is to use a conductive brush to contact one surface of the solar cell precursor and keep this surface dry, and to use photoinduced electroplating on the other surface of the solar cell precursor, for example CN101 796222B, in which a roller is used to transport the solar cell precursor and a conductive brush is used to provide electrical connection on the other surface of the solar cell precursor to be electroplated, this technology requires a metal layer to be deposited on the surface in contact with the conductive brush in advance, so it is not suitable for solar cell precursor structures that require electroplating metal grid lines on both surfaces, such as heterojunction cells or topcon cells, or for cells with metal grid lines only on one surface of the solar cell precursor, such as back contact cells (IBC or TBC structures), and the conductive brush is prone to scratching the surface of the cell.

Horizontal dual-surface electroplating technology usually uses a roller as the cathode material in contact with the conductive area of the solar cell precursor, or uses a roller with liquid to contact the conductive area of the solar cell precursor, for example, CN105590987A which uses electroplating solution as conductive medium to avoid hard contact. The difference between these two methods is that the roller itself is difficult to contact the surface of the solar cell precursor through the opening that forms in the mask of a certain thickness, and this disadvantage can be overcome by utilizing the conductivity of the ionic liquid. However, the ionic liquid and the surface of the solar cell precursor will form a local primary battery, which will cause corrosion of the metal on the surface of the solar cell precursor when there is no electricity, making it difficult to control the uniformity of electroplating and posing a certain reliability risk to the electrical performance of the solar cell precursor. When using a roller as a conductive cathode in contact with the solar cell precursor, a coating will also formed on the roller, therefore, it is necessary to carry out regular deplating treatment on the roller, which may cause downtime during normal production and affect equipment utilization and production capacity.

The disclosure of the above background technical content is only intended to assist in understanding the inventive concept and technical solution of this patent application, and does not necessarily belong to the prior art, and in the absence of clear evidence showing that the above content has been disclosed prior to the filing date of this patent application, the above background technical content should not be used to evaluate the novelty and inventiveness of this application.

### Summary

The purpose of the present disclosure is to provide a new method for electroplating a solar cell precursor, to solve one or more problems of the prior art.

To achieve the above purpose, a technical solution employed by the present disclosure is:
A method for electroplating a solar cell precursor, including:
providing a mask opening on a surface of a solar cell precursor to be electroplated, such that a conductive material layer of the solar cell precursor is exposed at a bottom of the mask opening;
attaching a first end portion of a flexible conductive piece to a bottom, a side wall and/or an edge of the mask opening, such that an electrical connection is formed between the conductive piece and the solar cell precursor.

Further, according to any technical solution or a combination of multiple technical solutions mentioned above, a single surface to be electroplated is attached to at least one conductive piece, the at least one conductive piece is a strip-shaped structure, and a second end portion of the conductive piece is directly or indirectly connected to a negative electrode of an external power supply for electroplating.

Further, according to any technical solution or a combination of multiple technical solutions mentioned above, a plurality of mask openings are provided on the surface to be electroplated extending in an intersecting manner, and at least two mask openings intersect to form an intersection area;
the first end portion of the conductive piece is fixedly attached to the intersection area.

Further, according to any technical solution or a combination of multiple technical solutions mentioned above, the mask openings are soaked in an electroplating solution, an electroplating anode is in contact with or immersed in the electroplating solution, and a positive electrode of the external power supply is electrically connected to the electroplating anode.

Further, according to any technical solution or a combination of multiple technical solutions mentioned above, the conductive piece is bendable, the solar cell precursor is horizontally arranged, and at least the first end portion of the conductive piece is bent, such that the second end portion of the conductive piece extends to a position apart from the electroplating solution.

Further, according to any technical solution or a combination of multiple technical solutions mentioned above, the indirect connecting the second end portion of the conductive piece to the negative electrode of the external power supply comprises: electrically connecting the second end portion of the conductive piece to a conductive connector, and forming an electrical connection to the negative electrode of the external power supply through the connector.

Further, according to any technical solution or a combination of multiple technical solutions mentioned above, the solar cell precursor is transferred through a surface treating tank, an electroplating tank, and a washing tank, wherein, during transferring the solar cell precursor through the electroplating tank, directions of movements of the conductive piece, the connector and the solar cell precursor are consistent.

Further, according to any technical solution or a combination of multiple technical solutions mentioned above, the connector is an attaching holder, and the second end portion of the conductive piece is fixedly attached to the attaching holder; or, the connector is a clamping jaw, and the second end portion of the conductive piece is fixedly clamped by the clamping jaw.

Further, according to any technical solution or a combination of multiple technical solutions mentioned above, after the electroplating is completed, the conductive piece is cut off and divided into a first part connected to the solar cell precursor and a second part connected to the connector,
the solar cell precursor is vacuum adsorbed to be fixed, and a force is applied to the conductive piece along a direction from the free end of the first part to the first end portion of the conductive piece, such that the first part is separated from the solar cell precursor;
and/or, the second part is separated from the connector by using a brush to wipe or chemical peel off.

Further, according to any technical solution or a combination of multiple technical solutions mentioned above, the connector is disconnected from the second end portion of the conductive piece, then the solar cell precursor is vacuum adsorbed, and a force is applied to the conductive piece along a direction from the second end portion of the conductive piece to the first end portion of the conductive piece, such that the conductive piece is separated from the solar cell precursor.

Further, according to any technical solution or a combination of multiple technical solutions mentioned above, the conductive piece is in a band shape or line shape, and the first end portion and the second end portion of the conductive piece are respectively arranged at opposite ends in a length direction of the conductive piece;
a single conductive piece has one first end portion and one second end portion, or, a single conductive piece has a plurality of first end portions and one second end portion.

Further, according to any technical solution or a combination of multiple technical solutions mentioned above, a plurality of mask openings are provided on the surface to be electroplated, and some or all of the plurality of mask openings are fixedly attached with the conductive piece.

Further, according to any technical solution or a combination of multiple technical solutions mentioned above, the solar cell precursor is horizontally placed, and has a front surface disposed upwards and a back surface disposed downwards, the surface to be electroplated is the front surface and/or the back surface, and each surface to be electroplated is provided with the mask opening and connected to the conductive piece.

Further, according to any technical solution or a combination of multiple technical solutions mentioned above, both the front surface and the back surface are surfaces to be electroplated, a plurality of mask openings are provided on the front surface extending in an intersecting manner, and a plurality of mask openings are provided on the back surface extending in an intersecting manner;
a same edge or two opposite edges of the front surface and the back surface are provided with mask opening nodes, wherein, the two opposite edges both extend along a transfer direction of the solar cell precursor;
at least two mask openings on the front surface intersect at the mask opening node of the front surface, and at least two mask openings on the back surface intersect at the mask opening node of the back surface;
the first end portion of the conductive piece is fixedly attached to the mask opening nodes of the front surface and the back surface.

Further, according to any technical solution or a combination of multiple technical solutions mentioned above, orthographic projections of the mask opening node of the front surface and the mask opening node of the back surface on the front surface of the solar cell precursor are spaced apart, or, orthographic projections of the mask opening node of the front surface and the mask opening node of the back surface on the back surface of the solar cell precursor are spaced apart.

Further, according to any technical solution or a combination of multiple technical solutions mentioned above, the sum of the number of mask opening node of the front surface and the number of mask opening node of the back surface is greater than 3, the number of mask opening nodes of the front surface and the number of mask opening nodes of the back surface are both greater than 0, and the orthographic projections of the mask opening nodes of the front surface and the mask opening nodes of the back surface on the front surface of the solar cell precursor are arranged alternately.

Further, according to any technical solution or a combination of multiple technical solutions mentioned above, the conductive piece is bonded to the mask opening and forms an electrical connection with the solar cell precursor.

Further, according to any technical solution or a combination of multiple technical solutions mentioned above, along a thickness direction, the conductive piece has a conductor layer and a conductive adhesive layer arranged on one side of the conductor layer, and the conductive adhesive layer is bonded to the mask opening.

Further, according to any technical solution or a combination of multiple technical solutions mentioned above, the conductor material of the conductor layer is one of or an alloy composed of more of copper, aluminum, nickel, and stainless steel, or the conductor layer is a multi-layer structure formed by stacking multiple materials from copper, aluminum, nickel, and stainless steel along the thickness direction; and/or, the conductive adhesive layer is a conductive pressure-sensitive adhesive layer, a conductive thermo-sensitive adhesive layer, or a non-woven conductive adhesive layer.

Further, according to any technical solution or a combination of multiple technical solutions mentioned above, the conductive piece further has a first film arranged on the other side of the conductor layer, and the first film is an insulating film or a hydrophobic film.

Further, according to any technical solution or a combination of multiple technical solutions mentioned above, the conductive piece further has a second film arranged on the outer side of the conductive adhesive layer, the second film is an insulating film or a hydrophobic film, and the conductive adhesive layer on the first end portion of the conductive piece is not covered by the second film.

According to another aspect of the present disclosure, an electroplating apparatus for a solar cell precursor is provided, which includes an electroplating tank for containing electroplating solution, an electroplating anode in contact with or immersed in the electroplating solution, an external power supply, and a conductive piece matched with the solar cell precursor to be electroplated, wherein, the positive electrode of the external power supply is configured to be electrically connected to the electroplating anode, the conductive piece is a flexible conductive strip-shaped structure, a first end portion of the conductive piece is configured to be electrically connected to the solar cell precursor provided with a mask opening, and a second end thereof is configured to be directly or indirectly electrically connected to the negative electrode of the external power supply.

Further, according to any technical solution or a combination of multiple technical solutions mentioned above, the solar cell precursor is horizontally arranged, and the conductive piece is bendable, such that the first end portion of the conductive piece is bent to extend the second end portion of the conductive piece to a position apart from the electroplating solution.

Further, according to any technical solution or a combination of multiple technical solutions mentioned above, the conductive piece is in a band shape or line shape, and the first end portion and the second end portion of the conductive piece are respectively arranged at opposite ends in a length direction of the conductive piece.

Further, according to any technical solution or a combination of multiple technical solutions mentioned above, along a thickness direction, the conductive piece has a conductor layer and a conductive adhesive layer arranged on one side of the conductor layer, and the conductive adhesive layer is configured to be bonded to the bottom, a side wall or an edge of the mask opening during the electroplating process of the solar cell precursor.

Further, according to any technical solution or a combination of multiple technical solutions mentioned above, the conductive piece further has a first film arranged on the other side of the conductor layer, and the first film is an insulating film or a hydrophobic film.

Further, according to any technical solution or a combination of multiple technical solutions mentioned above, the conductive piece further has a second film arranged on the outer side of the conductive adhesive layer, the second film is an insulating film or a hydrophobic film, and the conductive adhesive layer is exposed at least at the first end portion of the conductive piece.

Further, according to any technical solution or a combination of multiple technical solutions mentioned above, the electroplating apparatus further comprises a conductive connector located outside the electroplating tank, the connector is configured to be electrically connected to the negative electrode of the external power supply, and the second end portion of the conductive piece is fixedly connected to the connector.

Further, according to any technical solution or a combination of multiple technical solutions mentioned above, the connector is an attaching holder, and the second end portion of the conductive piece is fixedly attached to the attaching holder; or, the connector is a clamping jaw, and the second end portion of the conductive piece is fixedly clamped by the clamping jaw.

Further, according to any technical solution or a combination of multiple technical solutions mentioned above, the electroplating apparatus further comprises a transfer mechanism, and the transfer mechanism comprises a transfer rail for transferring the connector, and a roller mechanism for transferring the solar cell precursor.

Further, according to any technical solution or a combination of multiple technical solutions mentioned above, the electroplating tank is provided with an overflow port, and the electroplating apparatus further comprises an electroplating solution spraying system, and the electroplating solution spraying system at least comprises a nozzle for delivering the electroplating solution to the electroplating tank.

Further, according to any technical solution or a combination of multiple technical solutions mentioned above, the electroplating apparatus further comprises a circulating mechanism arranged on the electroplating tank and used for circulating the electroplating solution in the electroplating tank, the circulating mechanism comprises a second circulating assembly for realizing the circulation of the electroplating solution from a lower portion of the electroplating tank to an upper portion of the electroplating tank, and/or a third circulating assembly for realizing the circulation of the electroplating solution from an upper portion of the electroplating tank to a lower portion of the electroplating tank, and/or a first circulating assembly for realizing the circulation of the electroplating solution in a lower portion of the electroplating tank.

Further, according to any technical solution or a combination of multiple technical solutions mentioned above, the electroplating tank comprises an electroplating reaction tank body and a circulating replenishment tank body stacked on each other, and the electroplating reaction tank body is able to be arranged to overflow unidirectionally to the circulating replenishment tank body.

According to still another aspect of the present disclosure, a conductive piece for solar cell precursor electroplating is provided, which is a flexible conductive strip-shaped structure configured to be an electrical signal transduction element for electrically connecting the solar cell precursor to be electroplated with the negative electrode of a power supply for electroplating.

Further, according to any technical solution or a combination of multiple technical solutions mentioned above, the conductive piece comprises a conductive adhesive strip, at least one side of one end portion of the conductive adhesive stripe is exposed to bond to the exposed conductive material layer on the solar cell precursor to be electroplated or to the area adjacent to the exposed conductive material layer on the solar cell precursor.

Due to the use of the above technical solutions, the present disclosure has the following advantages over conventional art: the technical solutions of embodiments of the present disclosure can achieve electroplating of a metal material in the mask opening(s) on one or both surfaces of the solar cell precursor, and connect the mask opening(s) of the solar cell precursor through the flexible conductive piece, avoiding the problems of cracking or fragmentation caused by using hard conductors to clamp the solar cell precursor. After electroplating is completed, a predetermined force is applied to detach the flexible conductive piece from the solar cell precursor, and as a consumable used for a few times, the conductive piece does not need to be deplated after electroplating, saving time for deplating and improving the production efficiency of the electroplating apparatus.

### Brief Description of the Drawings

Fig. 1 is a schematic cross-sectional view of a flexible conductive piece in the first embodiment of the present disclosure;
Fig. 2 is a schematic cross-sectional view of a flexible conductive piece in the second embodiment of the present disclosure;
Fig. 3(a) is a schematic cross-sectional view of a flexible conductive piece in the third embodiment of the present disclosure;
Fig. 3(b) is a schematic cross-sectional view of a flexible conductive piece different from that in Fig. 3 (a) in this embodiment of the present disclosure;
Fig. 4 is a schematic diagram of the flexible conductive piece cut along the length direction in the third embodiment;
Fig. 5 is a schematic diagram of a flexible conductive piece attached to a plurality of mask openings on a surface of a solar cell precursor to be electroplated on one side in the fourth embodiment of the present disclosure;
Fig. 6 is a schematic diagram after the flexible conductive pieces are attached to the surfaces to be electroplated on both sides of the solar cell precursor according to the fifth embodiment of the present disclosure;
Fig. 7 is a schematic diagram when the flexible conductive pieces are attached to the surfaces to be electroplated on both sides of the solar cell precursor according to the fifth embodiment of the present disclosure;
Fig. 8 is a schematic diagram of the flexible conductive piece after bending based on Fig. 7;
Fig. 9 is a schematic diagram based on Fig. 8 when the solar cell precursor is supported on a roller mechanism;
Fig. 10 is a schematic diagram of the flexible conductive piece attached to surfaces of a solar cell precursor to be electroplated on both sides in another way and supported on a lower roller;
Fig. 11 is a schematic diagram of the distribution of mask openings and mask opening nodes on a surface of a solar cell precursor to be electroplated in a specific embodiment;
Fig. 12 is a schematic diagram of the cross-sectional structure of a solar cell precursor in a specific embodiment;
Fig. 13 is an enlarged view of Part A in Fig. 12;
Fig. 14 is a schematic diagram of the direction of attaching the conductive piece to a solar cell precursor;
Fig. 15 is a schematic diagram of the direction of force applied when the conductive piece is separated from the solar cell precursor after electroplating is completed;
Fig. 16 is a schematic diagram of the electroplating apparatus in the fifth embodiment of the present disclosure;
Fig. 17 is a schematic diagram of the electroplating tank in the fifth embodiment of the present disclosure;
wherein, 1 - conductive piece; 11 - conductor layer; 12 - conductive adhesive layer; 13 - first film; 14 - second film; 12a - first attachment area; 12b - second attachment area; 1A- first end portion; 1B - second end portion; 2 - solar cell precursor; 21 - solar cell precursor body; 210 - semiconductor structure layer; 211 - conductive material layer; 211a - ITO layer; 211b - seed layer; 22 - mask layer; 23 - mask opening; 231 - mask opening node; 232 - mask opening bottom; 233 - mask opening side wall; 234 - mask opening edge; 3 - external power supply; 4 - electroplating tank; 41 - electroplating reaction tank; 42 - circulating replenishment tank; 43 - first circulating pipeline; 44 - first circulating pump; 45 - second circulating pipeline; 46 - second circulating pump; 47 - third circulating pipeline; 4a - buffer tank; 4b - solar cell precursor channel; 5 - electroplating anode; 6 - connector; 7 - roller mechanism; 71 - lower roller; 72 - upper roller; 8 - transfer rail; 9 - conductor bus bar.

### Detailed Description of Exemplary Embodiments

The technical solution of the present disclosure is further described below combining with the accompanying drawings and specific embodiments.

In a method for electroplating a solar cell precursor of the present disclosure, a mask layer 22 on a surface of a solar cell precursor 2 to be electroplated is subjected to patterned opening processing to form a mask opening 23 on the surface of the solar cell precursor 2 to be electroplated, such that the conductive material layer 211 of the solar cell precursor 2 is exposed at a bottom of the mask opening 23, and the solar cell precursor 2 with the mask opening 23 on the surface to be electroplated is then subjected to electroplating processing to form a metal grid line on the surface of the solar cell precursor 2 to be electroplated. Wherein, the above-mentioned surface to be electroplated refers to a surface of the solar cell precursor 2 that needs to be formed with metal grid lines through electroplating process, and the surface on any of two sides of the solar cell precursor 2 in a thickness direction may be the above-mentioned surface to be electroplated. The patterned opening processing refers to forming a mask opening 23 on the mask layer 22 of the solar cell precursor 2, and causing the mask layer 22 with the mask opening 23 to form a predetermined pattern.

When electroplating the solar cell precursor 2, a flexible conductive piece 1 is used, and the conductive piece 1 is fixedly attached to the mask opening 23, so as to form an electrical connection between the conductive piece 1 and the solar cell precursor 2 during the electroplating process. The conductive piece 1 is fixedly attached to the mask opening 23, and may be fixedly connected through methods such as bonding, magnetic attraction, or stucking. In this application, bonding is preferably used to facilitate the rapid connection or disconnection between the conductive piece 1 and the mask opening 23 of the solar cell precursor 2.

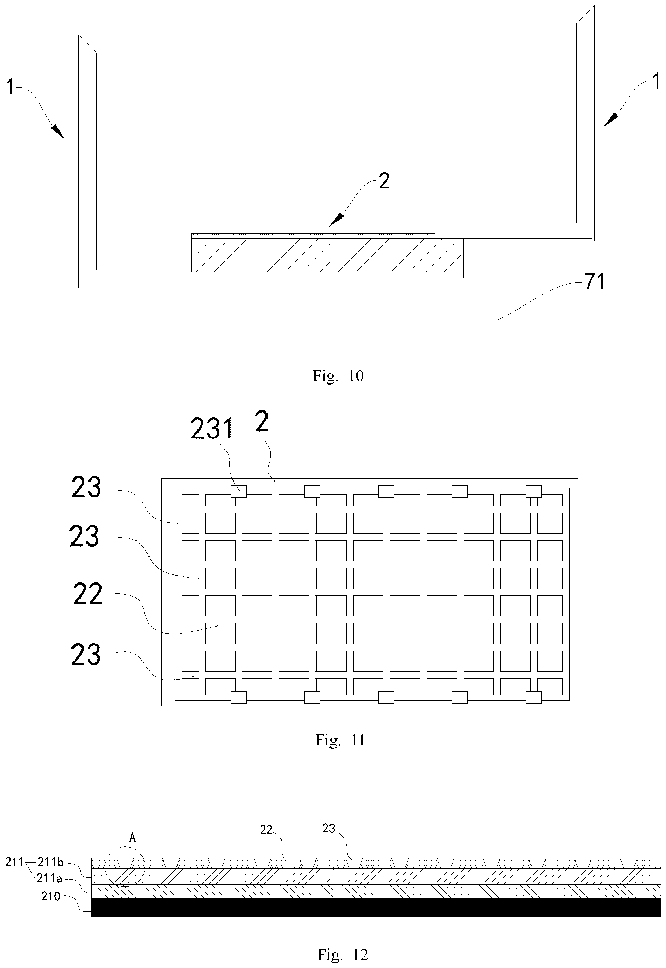

As shown in Fig. 12 to Fig. 13, the mask opening 23 comprises a mask opening bottom 232, a mask opening side wall 233, and a mask opening edge 234, the conductive piece 1 being fixedly attached to the mask opening 23 means that the conductive piece 1 is fixedly attached to the mask opening bottom 232, the mask opening side wall 233, or the mask opening edge 234, or, that the conductive piece 1 is fixedly attached to any two or three of the mask opening bottom 232, the mask opening side wall 233, and the mask opening edge 234. In some embodiments, the conductive piece 1 is a strip-shaped structure, and a single conductive piece 1 has a first end portion 1A and a second end portion 1B, the first end portions 1A of some conductive pieces 1 are attached to the mask opening bottom 232, the first end portions 1A of some conductive pieces 1 are attached to the mask opening side wall 233, or, the first end portions 1A of some conductive pieces 1 are attached to the mask opening edge 234, that is, the first end portions 1A of the conductive pieces 1 are directly or indirectly connected to the conductive material layer of the solar cell precursor, wherein, the way in which the first end portion 1A of the conductive piece 1 is attached to the mask opening bottom 232 is defined as a way of directly connecting the conductive material layer of the solar cell precursor, while the way in which the first end portion 1A of the conductive piece 1 is attached to the mask opening side wall 233 and the mask opening edge 234 is defined as a way of indirectly connecting the conductive material layer of the solar cell precursor, since that it does not contact the conductive material layer of the solar cell precursor, and the first end portion 1A of the conductive piece 1 needs to be soaked in a conductive electroplating solution to connect the conductive material layer of the solar cell precursor through the electroplating solution. In some embodiments, a single conductive piece 1 has a plurality of first end portions 1A (not shown) and one second end portion 1B, the plurality of first end portions 1A of one conductive piece 1 may be attached to different positions at the same mask opening 23 (any combination of the mask opening bottom 232, the mask opening side wall 233, and the mask opening edge 234), or may be attached to different mask openings 23.

The electrical connection here specifically refers to the connection between at least two conductors through physical contact, specifically, refer to Fig. 12, the solar cell precursor 2 comprises a solar cell precursor body 21, the solar cell precursor body 21 comprises a semiconductor structure layer 210 and a conductive material layer 211 arranged on the surface of the semiconductor structure layer 210, for the solar cell precursor shown in Fig. 12, its upper surface is the surface to be electroplated; for a double-sided electroplated solar cell precursor (not shown), the solar cell precursor body 21 comprises conductive material layers 211 provided on two sides of the semiconductor structure layer 210. The conductive material layer 211 comprises at least an ITO (Indium Tin Oxide, tin-doped indium oxide) layer 211a, and in some embodiments, the conductive material layer 211 further comprises a seed layer 211b covering the ITO layer 211a, the seed layer 211b is a conductive structure layer pre-arranged for preparing a grid line, and after the grid line preparation is completed, the part of the seed layer 211b that except below the grid line needs to be removed to expose the ITO layer 211a.

The above-mentioned seed layer 211b and ITO layer 211a are both conductive, the mask layer 22 covers the conductive material layer 211, the conductive material layer 211 is exposed from the mask opening 23, and the exposed part forms the mask opening bottom 232, and the conductive piece 1 is fixedly attached to the mask opening bottom 232, such that the conductive piece 1 is in direct contact with the conductive material layer 211 to form an electrical connection, or the conductive piece 1 is fixedly attached to the mask opening side wall 233 or the mask opening edge 234, although it is not in direct contact with the conductive material layer 211, an electrical connection is formed through the electroplating solution after the conductive piece 1 and the conductive material layer 211 are soaked in the electroplating solution. In some embodiments, when the conductive piece 1 is fixedly attached to the mask opening 23, it is in direct contact with the conductive material layer 211 to form an electrical connection, which can ensure that the current after power on is not too small and does not cause an increase of electroplating time.

A ring-shaped mask opening along the contour of the solar cell precursor on the edge of the surface to be electroplated is provided, one or more inner mask openings are provided, the ring-shaped mask opening may be a closed ring or a non-closed open ring, the inner mask opening(s) is provided in the internal area of the ring-shaped mask opening, and some or all of the inner mask opening(s) intersects with the ring-shaped mask opening. The first end portion 1A of the conductive piece 1 is connected to the area on the ring-shaped mask opening. Specifically, refer to Fig. 11, the solar cell precursor is rectangular (which may also be circular or irregular), and there is a plurality of mask openings 23 on the surface to be electroplated, comprising a rectangular ring-shaped mask opening, as well as a plurality of inner mask openings horizontally and vertically extending to intersect with the ring-shaped mask opening, however, this is not limited to the straight horizontal extension in Fig. 11, but corresponding patterned opening processing is made according to the layout of the metal grid line. Wherein, the plurality of mask openings 23 extending in an intersecting manner can intersect at one point, and such intersection forms intersection areas defined as mask opening nodes 231, and the conductive piece 1 is fixedly attached to the mask opening nodes 231, thereby achieving direct contact with the conductive material layer 211 and then forming an electrical connection with the solar cell precursor 2.

In other embodiments, when the conductive piece 1 is fixedly attached to the mask opening 23, the conductive piece 1 may be connected to the mask opening edge 234, an end portion of the conductive piece 1 and the mask layer 22 are both soaked in the electroplating solution, and the electrical connection between the conductive piece 1 and the mask opening bottom 232 is achieved through the conductivity of the electroplating solution. When the size of conductive piece 1 is small, it may also be connected to the mask opening bottom 232 or the mask opening side wall 233. These solutions do not require the additional provision of mask opening nodes 231, making the structure of the mask opening 23 simpler.

It should be noted that the mask opening node 231 mentioned above is an area for fixedly attaching and connecting the conductive piece 1, which has a certain surface area.

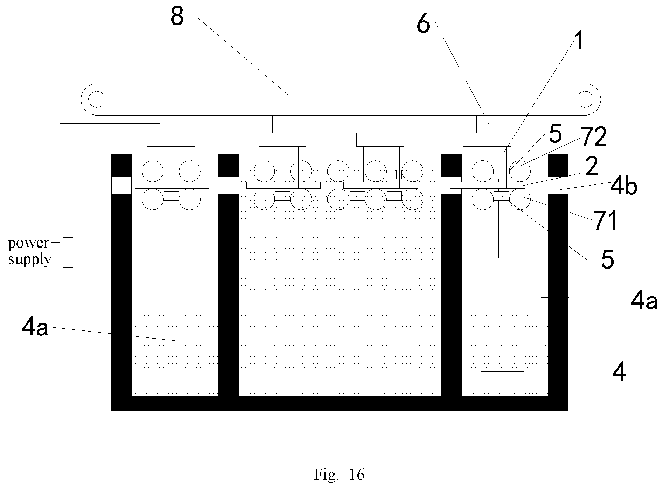

The shape of the conductive piece 1 is not limited in this application, and it may be in a band shape or line shape, may be in a strip shape or block shape, or may be in a regular shape or an irregular shape. The conductive piece 1 has a first end portion 1A and a second end portion 1B, as shown in Fig. 16, when electroplating the solar cell precursor 2, the mask opening 23 of the solar cell precursor 2 is soaked in the electroplating solution, the electroplating anode 5 is in contact with or immersed in the electroplating solution, the first end portion 1A of the conductive piece 1 is fixedly attached to the mask opening 23 of the surface to be electroplated of the solar cell precursor 2, the second end portion 1B of the conductive piece 1 is electrically connected to the negative electrode of the external power source 3, and the positive electrode of the external power source 3 is electrically connected to the electroplating anode 5. Specifically, the second end portion 1B of the conductive piece 1 may be directly connected to the negative electrode of the external power source 3, or the following indirect connection methods may also be adopted: the negative electrode of the external power source 3 is electrically connected to a conductive connector 6, and the second end portion 1B of the conductive piece 1 is electrically connected to the connector 6, such that through the connector 6, the electrical connection between the conductive piece 1 and the negative electrode of the external power source 3 is achieved, and the electrical connection between the conductive material layer 211 of the solar cell precursor 2 and the negative electrode of the external power source 3 is further achieved. In this way, the use of the conductive piece 1 realizes the electrical connection between the negative electrode of the external power supply 3 and the solar cell precursor 2, avoiding the problem of hidden cracks that may occur when the solar cell precursor is clamped by hard conductors. After electroplating is completed, a predetermined force is applied to tear off the conductive piece 1 fixedly attached to the mask opening of the solar cell precursor, and the separation of the conductive piece 1 and the solar cell precursor 2 can be completed. Although the position on the conductive piece 1 connected to the solar cell precursor 2 will also be electroplated, the cost of the conductive piece 1 is relatively low and may be used as a consumable, and the torn-off conductive piece 1 is directly treated as waste without the need for deplating, saving time for deplating the conductive piece 1 and improving the production efficiency of the electroplating apparatus.

It should be noted that flexibility in this application may also be interpreted as flexibleness, which is a property of an object relative to rigidity. Flexibility refers to a physical property in which an object undergoes deformation under force, and after the force is lost, the object itself cannot recover its original shape. After being subjected to force, the shape of a rigid object can be regarded as unchanged from a macroscopic perspective. For example, in this application, in order to facilitate the connection of the conductive piece 1 to the solar cell precursor 2, external force is used to bend the first end portion 1A of the conductive piece 1 to form a bent portion, and the shape of conductive piece 1 is changed; if there is no external force, the shape of the conductive piece 1 will not recover, and the bent portion will not disappear.

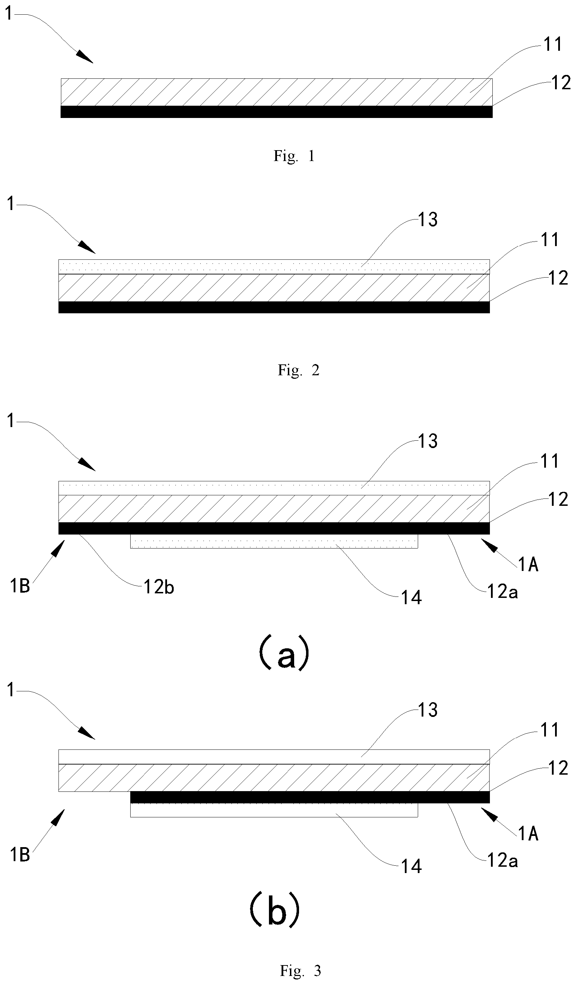

In an embodiment of the present disclosure, the conductive piece 1 is bonded to the mask opening 23 on the surface to be electroplated of the solar cell precursor 2 to form an electrical connection with the solar cell precursor 2, and is bonded to the connector 6 to form an electrical connection with the connector 6 to further achieve an electrical connection with the negative electrode of the external power source 3. That is to say, the connector 6 is specifically an attaching holder, and the conductive piece 1 is fixed to the mask opening 23 of the solar cell precursor 2 by way of adhesion and adhered to the connector 6 by bonding. Fig. 1, Fig. 2, Fig. 3 (a), and Fig. 3 (b) show schematic structural diagrams of different embodiments of the conductive piece 1.

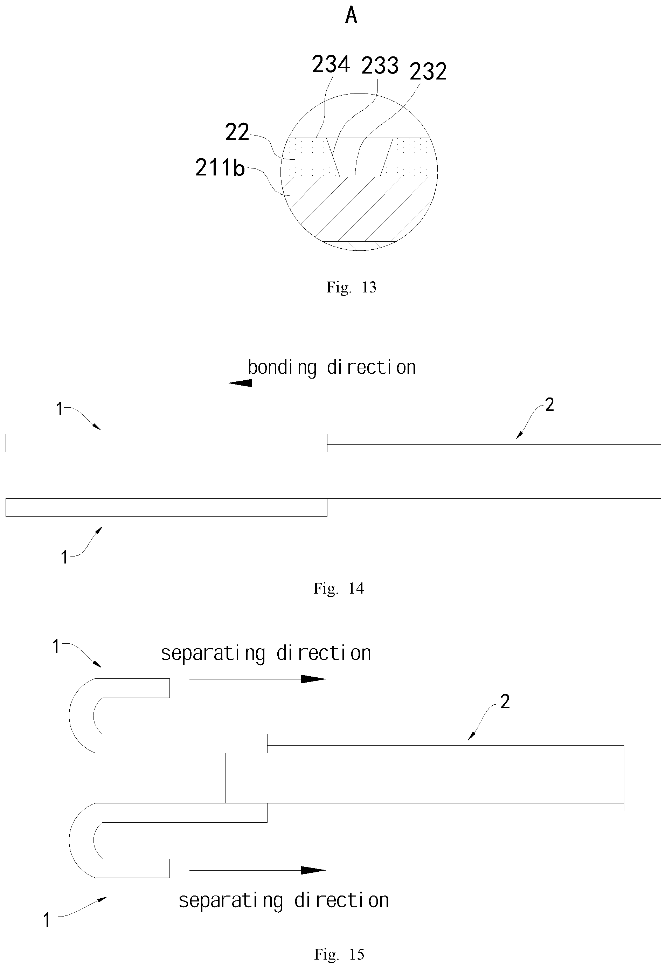

Referring to Fig. 1, a schematic diagram of the structure of the conductive piece 1 of the first embodiment is shown, along the thickness direction, the conductive piece 1 has a conductor layer 11 and a conductive adhesive layer 12 arranged on one surface of the conductor layer 11, both the conductor layer 11 and the conductive adhesive layer 12 are conductors, the conductive adhesive layer 12 has adhesion, the surface facing the conductor layer 11 may be bonded to the conductor layer 11, and the surface backing the conductor layer 11 may be fixedly bonded to the mask opening 23. By fixedly bonding the conductive adhesive layer 12 to the mask opening 23 of the solar cell precursor 2, the electrical connection with the solar cell precursor 2 is achieved. The conductor layer 11 has a conductor material of one of or an alloy material composed of more of copper, aluminum, nickel, and stainless steel, or is a multi-layer structure formed by stacking multiple materials from more of copper, aluminum, nickel, and stainless steel along the thickness direction; and/or, the conductive adhesive layer 12 is a conductive pressure-sensitive adhesive layer, a conductive thermo-sensitive adhesive layer, or a non-woven conductive adhesive layer, and the conductive adhesive layer 12 is to provide conductivity at least in a direction from the conductor layer 11 to the conductive adhesive layer 12. When electrically connecting the solar cell precursor 2 with the connector 6, the conductive adhesive layer 12 of the conductive piece 1 may be directly bonded to the solar cell precursor 2 and the connector 6, the bonding operation is simple. Fig. 14 shows the bonding direction of the conductive adhesive layer 12, starting from the free end of the first end portion 1A of the conductive piece 1, the conductive adhesive layer 12 is pressed onto the mask opening 23, and the conductive piece 1 is straightened, at this point, the direction in which the first end portion 1A of the conductive piece 1 oriented towards the second end portion 1B is the bonding direction.

Referring to Fig. 2, a schematic diagram of the structure of the conductive piece 1 of the second embodiment is shown, based on the first embodiment, the conductive piece 1 further has a first film 13 arranged on the other surface of the conductor layer 11, the first film 13 is an insulating film or a hydrophobic film, which is used to insulate or isolate this surface of the conductor layer 11 from the electroplating solution that may come into contact with the conductive piece 1, thereby reducing the electroplating area and avoiding the surface of the conductor layer 11 from being electroplated as well. Specifically, when configuring, the size and shape of cooperating surfaces of the first film 13 and the conductive piece 1 are the same, such that the conductor layer 11 is completely covered by the first film 13 on the other side surface.

Referring to Fig. 3(a), a schematic diagram of the structure of the conductive piece 1 of the third embodiment is shown, based on the second embodiment, the conductive piece 1 further has a second film 14 arranged on an outer surface of the conductive adhesive layer 12, the second film 14 also is an insulating film or a hydrophobic film, which is used to insulate or isolate the outer surface of the conductive adhesive layer 12 from the electroplating solution that may come into contact with the conductive piece 1, thereby reducing the electroplating area. This also makes the surface of the entire conductive piece 1 corrosion-resistant and provides better conductivity internally. The outer surface of the conductive adhesive layer 12 is not completely covered by the second film 14, such that the conductive adhesive layer 12 is exposed at least at the first end portion 1A of the conductive piece 1 for bonding to the mask opening 23. As shown in Fig. 3a, in this embodiment, the second film 14 covers the middle of the conductive adhesive layer 12, and the two end portions of the conductive adhesive layer 12 are exposed to form a first attachment area 12a and a second attachment area 12b. As shown in Fig. 3b, the conductive adhesive layer 12 is only exposed at the first end portion 1A of the conductive piece 1, the conductive adhesive layer 12 does not cover the second end portion 1B, and the second end portion 1B of the conductive piece 1 is electrically connected to the connector 6 through the conductor layer 11. It should be noted that the surface of conductive adhesive layer 12 that is in contact with the conductor layer 11 is the inner surface of the conductive adhesive layer 12, and the surface of the conductive adhesive layer 12 that is opposite to the conductor layer 11 is the outer surface.

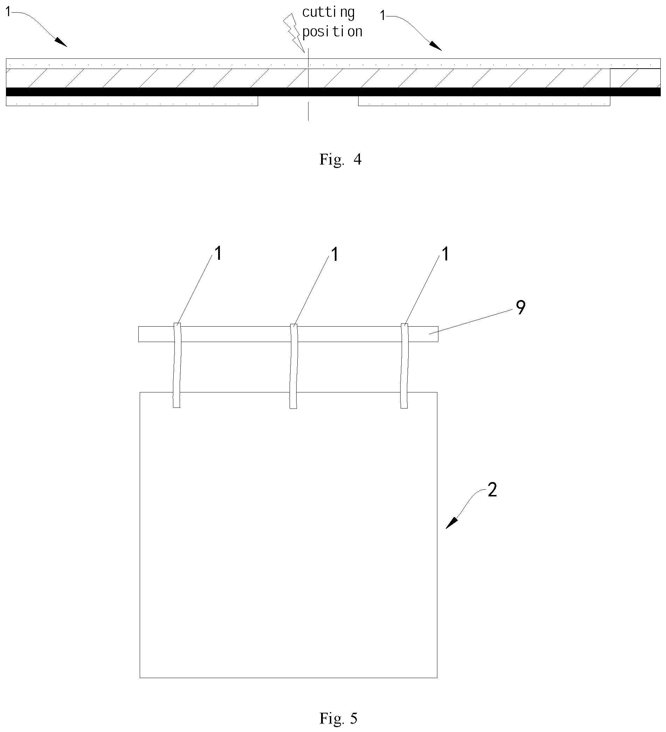

Preferably, the conductive piece 1 has a thickness of not less than 5 µm, and a length that may be a prefabricated length cut in sections or a continuous structure provided in a roll (referred to as a flexible conductive roll) capable of being wound on a reel. When the electroplating process use the conductive piece in the form of rolls, it can be unrolled according to the required length, then cut according to the method shown in Fig. 4, and then adhered to the mask opening 23 of the solar cell precursor 2. During the cutting process, a visual system can be used to recognize the cutting position and perform error correction processing, which can better reduce the electroplating area of the conductive adhesive layer 12, and the remaining conductive adhesive layer forms the first attachment area 12a and the second attachment area 12b, which are respectively bonded to the solar cell precursor 2 and the connector 6 to form electrical connections. When there is a cutting misalignment, the visual system can correct the cutting position to avoid the end of the conductive piece 1 connected to the solar cell precursor 2 being too short or the end used to connect the connector 6 being too short.

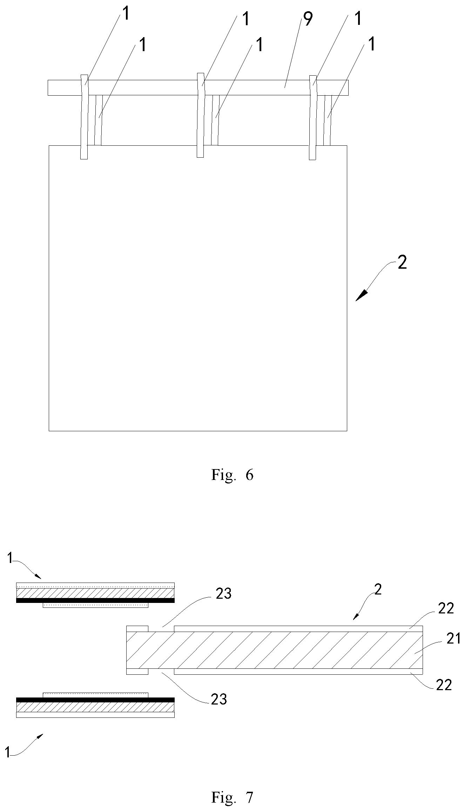

During electroplating, the solar cell precursor 2 is horizontally arranged, and the conductive piece 1 is bent along the length direction, as shown in Figures 7 - 10, such that the second end portion 1B of the conductive piece 1 can extend in a direction higher than the first end portion 1A of the conductive piece 1, until the second end portion 1B protrudes from the liquid level of the electroplating solution and is bonded to the connector 6.

In some other embodiments, the connector 6 is specifically a clamping jaw, and the second end portion 1B of the conductive piece 1 is fixedly clamped by the clamping jaw and forms an electrical connection with the clamping jaw. That is to say, the first end portion 1A of the conductive piece 1 is bonded to the mask opening 23 of the solar cell precursor 2 through the first attachment area 12a and forms an electrical connection with the solar cell precursor 2, the second end portion 1B of the conductive piece 1 is clamped by a clamping jaw, and the electrical connection between the conductive piece 1 and the clamping jaw is achieved through the contact between the second attachment area 12b and the clamping jaw. In other embodiments the second attachment area 12b is not provided on the second end portion 1B of the conductive piece 1, and the clamping jaw is directly clamped on the conductor layer 11. By clamping by this clamping jaw, a more stable connection can be formed, reducing the probability of the conductive piece 1 falling off from the connector 6. Of course, the specific form of the connector 6 is not limited to the attaching holder or clamping jaw mentioned above.

When electroplating, the solar cell precursor 2 is placed horizontally, the surface of the solar cell precursor 2 facing upwards is the front surface, the surface of the solar cell precursor 2 facing downwards is the back surface, one or both of the front surface and the back surface are the surfaces to be electroplated, and each surface to be electroplated is provided with a mask opening 23.

As shown in Fig. 11, a plurality of mask openings 23 is arranged side by side on the surface to be electroplated of the solar cell precursor 2, and all or some of the mask openings 23 are interconnected to form one or more connected patterns. The bottoms of the plurality of mask openings 23 are all conductive material layers 211, and the conductive material layers 211 are specifically conductive seed layers 211b or ITO layers 211a. Even if the plurality of mask openings 23 are not interconnected, these mask openings 23 may be electrically connected through the conductive material layers 211 at the bottoms, that is to say, only the conductive material layer 211 at the bottom of one mask opening 23 needs to be powered on, and the other mask openings 23 will also be powered on. One surface to be electroplated of the solar cell precursor 2 is at least connected to one conductive piece 1, to form a grid line by electroplating metal material in the plurality of mask openings 23. To improve the electroplating speed, all or some of the plurality of mask openings 23 are respectively connected to conductive pieces 1. Preferably, when there is a plurality of conductive pieces 1, the connection points of the conductive pieces 1 and the mask openings 23 are arranged at equal intervals, so that the surface to be electroplated of the solar cell precursor 2 is uniformly conductive, improving the electroplating uniformity of the surface to be electroplated of the solar cell precursor 2.

As shown in Fig. 11, the mask openings 23 are divided into vertical openings, horizontal openings, and ring-shaped openings, the mask opening node 231 is located at the intersection of the vertical openings or horizontal openings with the ring-shaped openings, the area of the mask opening node 231 is enlarged to facilitate the connection of the conductive piece 1 and facilitate machine vision guidance for bonding. After enlarging the area of the mask opening node 231, the conductive piece 1 can be directly connected to the conductive material layer 211 at the bottom of the mask opening node 231, achieving a larger area of contact electrical connection, increasing the electroplating current, and thus improving the electroplating efficiency.

As shown in Fig. 5, at least two of the mask openings 23 on the surface to be electroplated of the solar cell precursor 2 are respectively connected with conductive pieces 1, a plurality of conductive pieces 1 are arranged side by side and may be connected through a conductor busbar 9, and the conductor busbar 9 is then fixedly connected to the connector 6. Of course, the conductive pieces 1 may also be directly connected to the connector 6. In some embodiments, the conductor busbar 9 may also be integrated with the connector 6.

When the front surface and the back surface of the solar cell precursor are both the surfaces to be electroplated, at least two of the mask openings 23 on the front surface of the solar cell precursor 2 are respectively connected with the conductive pieces 1, at least two of all the mask openings 23 on the back surface of the solar cell precursor 2 are respectively connected with the conductive pieces 1, and these conductive pieces 1 are all connected to the conductor busbar 9, or directly connected to the connector 6.

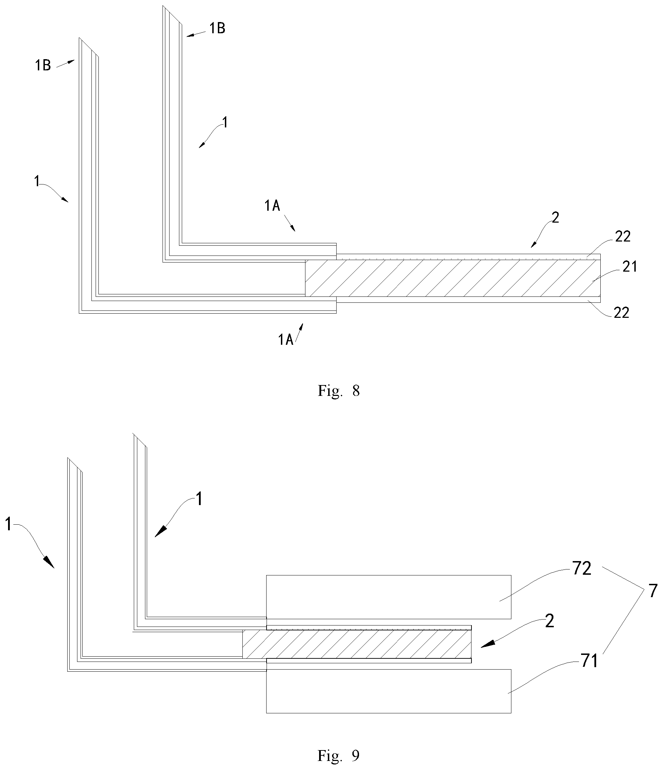

Preferably, the mask opening node 231 on the front surface of the solar cell precursor 2 that is actually connected to the conductive piece 1 is referred to as the first mask opening node; the mask opening node 231 on the back surface of the solar cell precursor 2 that is actually connected to the conductive piece 1 is referred to the second mask opening node. More preferably, the first mask opening node and the second mask opening node are arranged near the same edge of the solar cell precursor 2, and the same edge extends in the transfer direction of the solar cell precursor, as shown in Fig. 6 and Fig. 9.

More preferably, orthographic projections of the first mask opening node and the second mask opening node on the front surface of the solar cell precursor 2 are spaced apart, or orthographic projections of the first mask opening node and the second mask opening node on the back surface of the solar cell precursor 2 are spaced apart, and when the conductive piece 1 connected to the second mask opening node and the conductive piece 1 connected to the first mask opening node extend outwards (towards the connector 6 or the conductor busbar 9 or the external power source), the two will not interfere, making it convenient for all conductive pieces 1 to be connected to the conductor busbar 9 or the connector 6. More preferably, the sum of the number of first mask opening nodes and the number of second mask opening nodes is greater than 3, the number of first mask opening node and the number of second mask opening node are both greater than 0, and the orthographic projections of the first mask opening node and the second mask opening node on the front surface of the solar cell precursor 2 are arranged alternately, and when the conductive piece 1 connected to the second mask opening node is bent and extends to the front surface of the solar cell precursor 2, the conductive piece 1 connected to the first mask opening node will not interfere the conductive piece 1 connected to the second mask opening node, making it convenient for all conductive pieces 1 to be connected to the conductor busbar 9 or the connector 6, at the same time, when there is a plurality of first mask opening nodes, they can be arranged at intervals, and when there is a plurality of second mask opening nodes, they can be arranged at intervals, improving the electroplating uniformity of the solar cell precursor 2.

In some other embodiments, as shown in Fig. 10, the first mask opening node and the second mask opening node may be respectively arranged adjacent to the two opposite sides of the solar cell precursor 2, and the two opposite sides extend along the transfer direction of the solar cell precursor 2, as shown in Fig. 10.

During the electroplating process, the solar cell precursor 2 is transferred and processed sequentially through a surface treatment tank, an electroplating tank, a washing tank, and a blow-dry tank, during the transfer process of the solar cell precursor 2 through the electroplating tank, the conductive piece 1 is always connected between the solar cell precursor 2 and the connector 6, and the conductive piece 1, the connector 6, and the solar cell precursor 2 have consistent movement directions and the same speeds. Wherein, the surface treatment tank is an acid pickling tank, mainly used to remove impurities on the surface of the solar cell precursor 2 for subsequent electroplating; the electroplating tank is used for electroplating metal at the mask opening 23 of the solar cell precursor 2. Preferably, the electroplating tank comprises a copper plating tank and a tin plating tank, the solar cell precursor 2 is first electroplated in the copper plating tank to form a copper grid line, and then electroplated in the tin plating tank to form a tin coating on the surface of the copper grid line. In this way, immediately after completing copper electroplating, tin electroplating is applied to the surface of the copper grid line to avoid the problem of oxidation of the copper grid line and protect the copper grid line; the washing tank is used to clean the surface of the solar cell precursor 2 to remove impurities and residual electroplating solution, and it may be sprayed with water or soaked in water; the blow-dry tank is used to blow air onto the surface of the solar cell precursor 2, reducing the amount of liquid carried by solar cell precursor 2. The blow-dry tank is arranged downstream of the electroplating tank. Preferably, the blow-dry tank comprises a wind blade mechanism capable of blowing air onto the solar cell precursor 2 to reduce the amount of liquid carried on the surface of the solar cell precursor 2.

During the electroplating process, the solar cell precursor 2 and the connector 6 are synchronously transferred by a transfer mechanism, specifically, the transfer mechanism comprises a transfer rail 8 for transferring the solar cell precursor 2 and a roller mechanism 7 for transferring the solar cell precursor 2, and the connector 6 is fixedly arranged on the transfer rail 8 and transported by the transfer rail 8. During operation, a driving component drives the transfer rail 8 to work, driving the connector 6 and the conductive piece 1 connected thereto to move along the transfer direction of the solar cell precursor 2, and causing the conductive piece 1 and the solar cell precursor 2 connected to the conductive piece 1 to move at the same speed and in same direction. In some embodiments, the roller mechanism 7 only comprises a lower roller 71, as shown in Fig. 10, during transferring, the lower roller 71 provides support for the solar cell precursor 2, and the solar cell precursor 2 advances under the pulling action of the conductive piece 1. In some other embodiments, the roller mechanism 7 comprises an upper roller 72 and a lower roller 71 that cooperate with each other, as shown in Fig. 9 and Fig. 16, the upper roller 72 and the lower roller 71 cooperate with each other to transfer the solar cell precursor 2, in this way, the lower roller 71 is completely immersed in the electroplating solution, and the upper roller 72 is partially immersed in the electroplating solution, such that the solar cell precursor 2 is completely immersed. The electroplating anode 5 is located between two adjacent upper rollers 72 and/or between two adjacent lower rollers 71, and is arranged opposite to the surface to be electroplated of the solar cell precursor 2, such that the electroplating anode 5 is at least partially immersed in the electroplating solution to achieve the electroplating function. In other embodiments, only the back surface of the solar cell precursor 2 is electroplated, the lower roller 71 is completely immersed in the electroplating solution, and the upper roller 72 may not be immersed in the electroplating solution, as long as the back surface of the solar cell precursor 2 is completely immersed.

After electroplating is completed, the conductive piece 1 is disconnected from the solar cell precursor 2 and the connector 6, and the specific steps may be implemented as follows: first, cutting the conductive piece 1, dividing the conductive piece 1 into a first part connected to the solar cell precursor 2 (the first end portion 1A belongs to this first part), and a second part connected to the connector 6 (the second end portion 1B of the conductive piece 1 belongs to this second part), then, separating the first part from the solar cell precursor 2 and the second part from the connector 6. When separating the first part from the solar cell precursor 2, it is preferable to vacuum adsorb the solar cell precursor 2 and apply force in the opposite direction of the direction of bonding the conductive piece 1 to the mask opening 23 (i.e., after straightening the first part bonded to the mask opening 23, its first end portion 1A is oriented towards the cutting direction) to peel off the first part, as shown in Fig. 15, such that the first part is separated from the solar cell precursor 2; when separating the second part from the connector 6, a method of using a brush to wipe or chemical peeling may be used to separate the second part from the connector 6, wherein, brush wiping refers to using a brush to wipe the connection between the second part and the connector 6 multiple times, so that the second part is separated from the connector 6; after the second part is separated from the connector 6, the brush may be used to continue wiping the connection area on the connector 6 to remove any adhered residue. Chemical peeling refers to that an adhesive remover or alkaline solution is used to soak the connection between the second part and the connector 6, so that the second part peels off from the connector 6 while removing any residue adhered to the connector 6.

In some other embodiments, when the connector 6 is a clamping jaw, the second end portion 1B of the conductive piece 1 is clamped by the clamping jaw, after electroplating is completed, the clamping jaw releases the second end portion 1B, so there is no need to cut the conductive piece 1, at this time, after the clamping jaw has released the second end portion 1B, the first end portion 1A of the conductive piece 1 is then separated from the solar cell precursor 2.

As shown in Fig. 16, the electroplating apparatus further comprises an electroplating tank 4 for containing the electroplating solution, the electroplating anode 5 and the roller mechanism 7 are both located in the electroplating tank 4, the connector 6 is located above the electroplating tank 4, and the external power supply 3 is located outside the electroplating tank 4. The electroplating tank 4 is provided with a solar cell precursor channel 4b for the solar cell precursor 2 to enter the electroplating tank 4 along the transfer direction, buffer tanks 4a are provided upstream and downstream of the electroplating tank 4, and the liquid in the electroplating tank 4 can overflow into the buffer tanks 4a. The electroplating apparatus further comprises an electroplating solution spraying system (not shown), the electroplating solution spraying system at least comprises a nozzle, the outlet of the nozzle is located above the electroplating tank 4, and during the electroplating process, the electroplating solution spraying system can spray the electroplating solution into the electroplating tank 4 to achieve the purpose of replenishment. By overflow and spraying replenishment, the concentration of the electroplating solution in the electroplating tank 4 is ensured, and the flow of the electroplating solution in the electroplating tank 4 is increased, making the concentration of the electroplating solution in the electroplating tank 4 more uniform, which is beneficial for the uniform electroplating of the solar cell precursor 2.

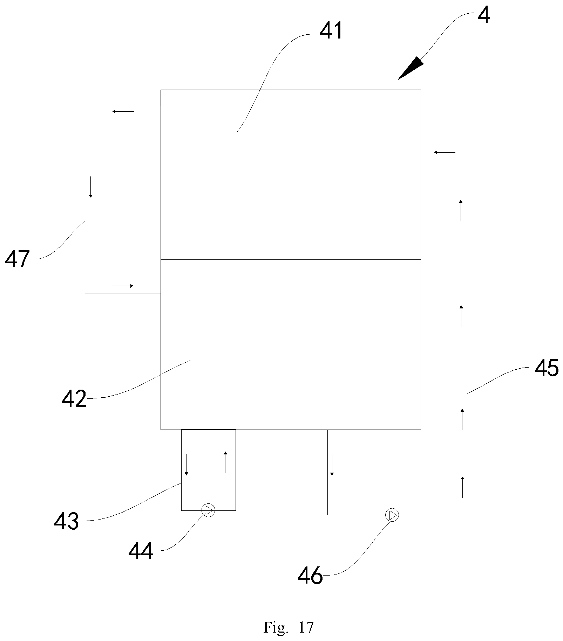

Refer to Fig. 17, the electroplating apparatus further comprises a circulating mechanism arranged on the electroplating tank 4 and used for circulating the electroplating solution in the electroplating tank 4. The circulating mechanism comprises a second circulating assembly for realizing the circulation of the electroplating solution from a lower portion of the electroplating tank 4 to an upper portion of the electroplating tank 4, and/or a third circulating assembly for realizing the circulation of the electroplating solution from an upper portion of the electroplating tank 4 to a lower portion of the electroplating tank 4, and/or a first circulating assembly for realizing the circulation of the electroplating solution in a lower portion of the electroplating tank 4.

As shown in Fig. 17, in this embodiment, the first circulating assembly comprises a first circulating pipeline 43 and a first circulating pump 44 arranged on the first circulating pipeline 43, and the two ends of the first circulating pipeline 43 are respectively connected to the bottom wall of the electroplating tank 4 or the lower side wall of the electroplating tank 4. Here, both ends of the first circulating pipeline 43 are connected to the bottom wall of the electroplating tank 4 and connected to the cavity of the electroplating tank 4. In other embodiments, both ends of the first circulating pipeline 4 may be connected to the lower side wall of the electroplating tank 4, or both ends of the first circulating pipeline 43 may be connected to the bottom wall of the electroplating tank 4 and the lower side wall of the electroplating tank 4, respectively. When the first circulating pump 44 is working, it can circulate the electroplating solution in the lower portion of the electroplating tank 4 through the first circulating pipeline 43, and then achieve a disturbance of the electroplating solution in the lower portion of the electroplating tank 4 to evenly distribute the electroplating solution, especially to evenly distribute the electroplating solution in the lower portion of the electroplating tank 4.

In this embodiment, the second circulating assembly comprises a second circulating pipeline 45 and a second circulating pump 46, one end portion of the second circulating pipeline 45 is connected to the bottom wall of the electroplating tank 4 or the lower side wall of the electroplating tank 4, and the other end portion of the second circulating pipeline 45 is connected to the upper side wall of the electroplating tank 4 or above the tank opening of the electroplating tank 4. Here, specifically, the lower end portion of the second circulating pipeline 45 is connected to the bottom wall of the electroplating tank 4, and the upper end portion of the second circulating pipeline 45 is connected to the upper side wall of the electroplating tank 4. The second circulating pump 46 is used to drive the electroplating solution to flow from bottom to top along the second circulating pipeline 45, thereby pumping the electroplating solution from the lower portion of the electroplating tank 4 into the upper portion of the electroplating tank 4. In this way, it is possible to achieve the circulation of the electroplating solution in the upper portion of the electroplating tank 4 and the electroplating solution in the lower portion of the electroplating tank 4, thereby achieving the disturbance of the electroplating solution in the entire electroplating tank 4, such that the electroplating solution in the entire electroplating tank 4 is evenly distributed.

In this embodiment, the electroplating tank 4 comprises an electroplating reaction tank 41 and a circulating replenishment tank 42, the electroplating reaction tank 41 is located above the circulating replenishment tank 42, the inner cavity of the electroplating reaction tank 41 forms the upper portion of the electroplating tank 4, the inner cavity of the circulating replenishment tank 42 froms the lower portion of the electroplating tank 4, the solar cell precursor 2 undergoes electroplating in the inner cavity of the electroplating reaction tank 41, and the electroplating reaction tank 41 and the circulating replenishment tank 42 are not in communication with each other. The third circulating assembly comprises a third circulating pipeline 47 connected between the electroplating reaction tank 41 and the circulating replenishment tank 42, one end portion of the third circulating pipeline 47 is connected to the upper portion of the electroplating reaction tank 41, and the other end thereof is connected to the upper portion of the circulating replenishment tank 42. Under the action of gravity, the electroplating solution in the upper portion of the electroplating reaction tank 41 can enter the circulating replenishment tank 42, at the same time, by continuously replenishing the electroplating solution to the electroplating reaction tank 41, the electroplating solution in the electroplating reaction tank 41 can be evenly distributed. In some other embodiments, the third circulating assembly may further comprise a third circulating pump for pumping the electroplating solution from the upper portion of the electroplating reaction tank 41 into the circulation replenishment tank 42. In other embodiments, when the electroplating reaction tank 41 and the circulating replenishment tank 42 arranged in the up-down direction is in communication with each other, a third circulating pump may further be arranged to pump the electroplating solution from the upper portion of the electroplating reaction tank 41 into the circulating replenishment tank 42.

In some other embodiments, when the cavity of the electroplating reaction tank 41 is not in communication with the cavity of the circulating replenishment tank 42, the electroplating reaction tank 41 and the circulating replenishment tank 42 may not be arranged in the up-down direction, and the first circulating assembly, the second circulating assembly, and the third circulating assembly realize the corresponding circulation flows of the electroplating solution through the first circulating pump 44, the second circulating pump 46, and the third circulating pump, respectively.

In some other embodiments, the third circulating assembly is not provided, the electroplating reaction tank 41 and the circulating replenishment tank 42 of the electroplating tank 4 are arranged in a manner of being stacked on each other, and the electroplating reaction tank 41 can be arranged to overflow unidirectionally to the circulating replenishment tank 42, in this way, the electroplating reaction tank 41 is continuous replenished, and the electroplating solution in the upper portion of the electroplating reaction tank 41 overflows outwards to the circulating replenishment tank 42, which can also achieve dynamic balance and uniform distribution of the electroplating solution in the electroplating reaction tank 41.

The specific implementation steps of the electroplating method in this embodiment are exemplarily illustrated below by combining the schematic diagram of the electroplating apparatus shown in Fig. 16 and the electroplating process of the solar cell precursor 2 with both the front surface and the back surface to be electroplated.
(1) Performing the patterned opening processing to the mask layers 22 on the front surface and the back surface of the solar cell precursor 2 to be electroplated, and forming mask openings 23 on the surfaces to be electroplated on both sides.
(2) Bonding the first end portions 1A of the conductive pieces 1 to the mask openings 23 on the surfaces to be electroplated on both sides, where part or some of the plurality of mask openings 23 on the surface to be electroplated on the same side is connected with the conductive pieces 1; bonding the second end portions 1B of the conductive pieces 1 to the connector 6 and forming an electrical connection with the connector 6; electrically connecting the negative electrode of the external power supply 3 to the connector 6, and electrically connecting the positive electrode of the external power supply 3 to two electroplating anodes 5; the upper roller 72 and lower roller 71 of the roller mechanism 7 cooperate with each other to transport the solar cell precursor 2, the roller mechanism 7 is disposed in the electroplating tank 4, the lower roller 71 is fully immersed in the electroplating solution, more than half of the height of the upper roller 72 is immersed in the electroplating solution, one electroplating anode 5 is located between two adjacent lower rollers 71 and the electroplating working surface of this electroplating anode 5 is opposite to the back surface of the solar cell precursor 2, and the other electroplating anode 5 is located between two adjacent upper rollers 72 and the electroplating working surface of this electroplating anode 5 is opposite to the front surface of the solar cell precursor 2. The above two electroplating anodes 5 are immersed in or in contact with the electroplating solution.
(3) The transfer mechanism transfers the solar cell precursor 2, the connector 6, and the conductive piece 1 at the same speed and in same direction, such that the solar cell precursor 2 passes through the surface treatment tank, the electroplating tank, the washing tank, and the blow-dry tank in sequence for corresponding process treatment.
(4) Cutting the conductive piece 1 at the position between the first end portion 1A and the second end portion 1B, then vacuum adsorbing the solar cell precursor 2, and applying force to the conductive piece 1 on the solar cell precursor 2 in the opposite direction of bonding to the solar cell precursor 2, such that the conductive piece 1 is separated from the solar cell precursor 2; an adhesive remover or alkaline solution is used to soak the connection between the second part and the connector 6, such that the conductive piece 1 peels off from the connector 6 while removing any residue adhered to the connector 6.

In the above electroplating process, the conductive piece 1 provides electrical connection between the solar cell precursor 2 and the connector 6 and the negative electrode of the external power supply 3, it can achieve electroplating of metal material in the mask openings 23 of the solar cell precursor 2 without hard clamping joints at the connection position, avoiding the problem of cracking or fragmentation caused by hard conductive clamping joints clamping the solar cell precursor in the conventional art, and after electroplating is completed, a predetermined force is applied to the conductive pieces 1 bonded to the mask openings 23 of the solar cell precursor 2, and the separation of the conductive piece 1 and the solar cell precursor 2 can be completed without the need for deplating treatment, which is efficient and convenient.

The embodiments described above are only for illustrating the technical concepts and features of the present disclosure, and are intended to make a person familiar with the technology being able to understand the content of the present disclosure and thereby implement it, and should not limit the protective scope of this disclosure. Any equivalent variations or modifications according to the spirit of the present disclosure should be covered by the protective scope of the present disclosure.

## Claims

1. A method for electroplating a solar cell precursor, **characterized in that,** the method comprises:
providing a mask opening on a surface of a solar cell precursor to be electroplated, such that a conductive material layer of the solar cell precursor is exposed at a bottom of the mask opening;
directly or indirectly connecting a first end portion of a conductive piece to the conductive material layer of the solar cell precursor, such that an electrical connection is formed between the conductive piece and the solar cell precursor;
wherein, the conductive piece is a flexible structure capable of being bent.

2. The method for electroplating a solar cell precursor of claim 1, **characterized in that,** the first end portion of the conductive piece is fixedly attached to the mask opening.

3. The method for electroplating a solar cell precursor of claim 2, **characterized in that,**
a plurality of mask openings are provided on the surface to be electroplated, and at least two of the mask openings are intersected to form an intersection area;
the first end portion of the conductive piece is fixedly attached to the intersection area.

4. The method for electroplating a solar cell precursor of claim 1, **characterized in that,** the solar cell precursor is horizontally placed, the solar cell precursor has a front surface disposed upwards and a back surface disposed downwards, the surface to be electroplated is the front surface and/or the back surface, and each surface to be electroplated is provided with the mask opening.

5. The method for electroplating a solar cell precursor of claim 4, **characterized in that,** the front surface and the back surface are both surfaces to be electroplated, and mask opening nodes are provided on the mask openings, the conductive piece is fixedly attached to the mask opening nodes and forms electrical connection with the solar cell precursor at the mask opening nodes, wherein, the mask opening node on the front surface of the solar cell precursor that is connected to the conductive piece is referred to a first mask opening node, and the mask opening node on the back of the solar cell precursor that is connected to the conductive piece is referred to a second mask opening node,
the first mask opening node and the second mask opening node are located adjacent to a same edge of the solar cell precursor, and the same edge extends in a transfer direction of the solar cell precursor; or, the first mask opening node and the second mask opening node are respectively located adjacent to two opposite edges of the solar cell precursor, and both the two opposite sides extend along a transfer direction of the solar cell precursor.

6. The method for electroplating a solar cell precursor of claim 5, **characterized in that,** orthographic projections of the first mask opening node and the second mask opening node on the front surface of the solar cell precursor are spaced apart, or, orthographic projections of the first mask opening node and the second mask opening node on the back surface of the solar cell precursor are spaced apart.

7. The method for electroplating a solar cell precursor of claim 5, **characterized in that,** a sum of a number of first mask opening node and a number of second mask opening node is greater than 3, the number of first mask opening node and the number of second mask opening node are both greater than 0, and the orthographic projections of the first mask opening node and the second mask opening node on the front surface of the solar cell precursor are arranged alternately.

8. The method for electroplating a solar cell precursor of claim 1, **characterized in that,** providing the mask opening on the surface of the solar cell precursor to be electroplated comprises: providing a ring-shaped mask opening along a contour of the solar cell precursor on an edge of the surface to be electroplated, providing one or more inner mask openings, where the inner mask opening(s) is provided in an internal area of the ring-shaped mask opening, and some or all of the inner mask opening(s) intersects with the ring-shaped mask opening;
connecting the first end portion of the conductive piece to an area in the ring-shaped mask opening.

9. The method for electroplating a solar cell precursor of claim 1, **characterized in that,** directly or indirectly connecting a second end portion of the conductive piece to a negative electrode of an external power supply for electroplating; soaking the mask opening in an electroplating solution, making an electroplating anode contact or immerse in the electroplating solution, and electrically connecting a positive electrode of the external power supply to the electroplating anode.

10. The method for electroplating a solar cell precursor of claim 9, **characterized in that,** the conductive piece is bendable, the solar cell precursor is horizontally arranged, and at least the first end portion of the conductive piece is bent, such that the second end portion of the conductive piece extends to a position apart from the electroplating solution.

11. The method for electroplating a solar cell precursor of claim 9, **characterized in that,** the indirect connecting the second end portion of the conductive piece to the negative electrode of the external power supply comprises: electrically connecting the second end portion of the conductive piece to a conductive connector, and forming an electrical connection to the negative electrode of the external power supply through the connector.

12. The method for electroplating a solar cell precursor of claim 11, **characterized in that,** the solar cell precursor is transferred through a surface treating tank, an electroplating tank, and a washing tank, wherein, during transferring the solar cell precursor through the electroplating tank, directions of movements of the conductive piece, the connector and the solar cell precursor are consistent.

13. The method for electroplating a solar cell precursor of claim 11, **characterized in that,** the connector is an attaching holder, and the second end portion of the conductive piece is fixedly attached to the attaching holder; or, the connector is a clamping jaw, and the second end portion of the conductive piece is fixedly clamped by the clamping jaw.

14. The method for electroplating a solar cell precursor of claim 11, **characterized in that,** after electroplating is completed, cutting off the conductive piece and dividing the conductive piece into a first part connected to the solar cell precursor and a second part connected to the connector,
vacuum adsorbing to fix the solar cell precursor, and applying a force to a free end of the first part along a bonding direction or an opposite direction of the bonding direction, such that the first part is separated from the solar cell precursor; and/or,
the second part is separated from the connector by using a brush to wipe or chemical peel off.

15. The method for electroplating a solar cell precursor of claim 11, **characterized in that,** after electroplating is completed, first disconnecting the connector from the second end portion of the conductive piece, then vacuum adsorbing the solar cell precursor, and applying a force to the second end portion of the conductive piece along a bonding direction or an opposite direction of the bonding direction, such that the conductive piece is separated from the solar cell precursor.

16. The method for electroplating a solar cell precursor of claim 9, **characterized in that,** the conductive piece is in a band shape or line shape, and the first end portion and the second end portion of the conductive piece are respectively arranged at opposite ends in a length direction of the conductive piece.

17. The method for electroplating a solar cell precursor of claim 1, **characterized in that,** a plurality of mask openings are provided on the surface to be electroplated, and some or all of the plurality of mask openings are fixedly attached with the conductive piece.

18. The method for electroplating a solar cell precursor of any one of claims 1 to 17, **characterized in that,** the conductive piece is bonded to the mask opening and forms an electrical connection with the solar cell precursor.

19. The method for electroplating a solar cell precursor of claim 18, **characterized in that,** along a thickness direction, the conductive piece has a conductor layer and a conductive adhesive layer arranged on one side of the conductor layer, and the conductive adhesive layer is bonded to the mask opening.

20. The method for electroplating a solar cell precursor of claim 19, **characterized in that,** a conductor material of the conductor layer is one of or an alloy composed of more of copper, aluminum, nickel, and stainless steel, or the conductor layer is a multi-layer structure formed by stacking multiple materials from more of copper, aluminum, nickel, and stainless steel along the thickness direction; and/or, the conductive adhesive layer is a conductive pressure-sensitive adhesive layer, a conductive thermo-sensitive adhesive layer, or a non-woven conductive adhesive layer.

21. The method for electroplating a solar cell precursor of claim 19, **characterized in that,** the conductive piece further has a first film arranged on the other side of the conductor layer, and the first film is an insulating film or a hydrophobic film.

22. The method for electroplating a solar cell precursor of claim 21, **characterized in that,** the conductive piece further has a second film arranged on an outer side of the conductive adhesive layer, the second film is an insulating film or a hydrophobic film, and the conductive adhesive layer on the first end portion of the conductive piece is not covered by the second film.

23. An electroplating apparatus for a solar cell precursor, **characterized in that,** the electroplating apparatus comprises an electroplating anode and an external power supply, wherein, a positive electrode of the external power supply is configured to be electrically connected to the electroplating anode, and a negative electrode of the external power supply is capable of being electrically connected to the solar cell precursor through a flexible conductive piece.

24. The electroplating apparatus for a solar cell precursor of claim 23, **characterized in that,** a surface of the solar cell precursor to be electroplated is provided with a mask opening, a bottom of the mask opening exposes a conductive material layer of the solar cell precursor; the conductive piece comprises a first end portion and a second end portion, the first end portion of the conductive piece is capable of being directly or indirectly connected to the conductive material layer of the solar cell precursor, such that an electrical connection is formed between the conductive piece and the solar cell precursor, and the second end portion of the conductive piece is capable of being directly or indirectly connected to the negative electrode of the external power supply.

25. The electroplating apparatus for a solar cell precursor of claim 24, **characterized in that,** the electroplating apparatus further comprises an electroplating tank for containing electroplating solution, in an operating or debugging state, the electroplating anode is in contact with or immersed in the electroplating solution, and the first end portion of the conductive piece is bendable, such that the second end portion of the conductive piece extends to a position apart from the electroplating solution.

26. The electroplating apparatus for a solar cell precursor of claim 24, **characterized in that,** the conductive piece is in a band shape or line shape, and the first end portion and the second end portion of the conductive piece are respectively arranged at opposite ends in a length direction of the conductive piece.

27. The electroplating apparatus for a solar cell precursor of claim 24, **characterized in that,** along a thickness direction, the conductive piece has a conductor layer and a conductive adhesive layer arranged on one side of the conductor layer, and the conductive adhesive layer is bonded to the mask opening.

28. The electroplating apparatus for a solar cell precursor of claim 27, **characterized in that,** the conductive piece further has a first film arranged on the other side of the conductor layer, and the first film is an insulating film or a hydrophobic film.

29. The electroplating apparatus for a solar cell precursor of claim 28, **characterized in that,** the conductive piece further has a second film arranged on an outer side of the conductive adhesive layer, the second film is an insulating film or a hydrophobic film, and the conductive adhesive layer on the first end portion of the conductive piece is not covered by the second film.

30. The electroplating apparatus for a solar cell precursor of claim 24, **characterized in that,** the electroplating apparatus further comprises a conductive connector, the connector is configured to be electrically connected to the negative electrode of the external power supply, and the second end portion of the conductive piece is capable of being fixedly connected to the connector.

31. The electroplating apparatus for a solar cell precursor of claim 30, **characterized in that,** the connector is an attaching holder, and the second end portion of the conductive piece is fixedly attached to the attaching holder; or, the connector is a clamping jaw, and the second end portion of the conductive piece is fixedly clamped by the clamping jaw.

32. The electroplating apparatus for a solar cell precursor of claim 30, **characterized in that,** the electroplating apparatus further comprises a transfer mechanism, and the transfer mechanism comprises a transfer rail for transferring the connector, and a roller mechanism for transferring the solar cell precursor.

33. The electroplating apparatus for a solar cell precursor of claim 25, **characterized in that,** the electroplating tank is provided with an overflow port, the electroplating apparatus further comprises an electroplating solution spraying system, and the electroplating solution spraying system at least comprises a nozzle for delivering the electroplating solution to the electroplating tank.

34. The electroplating apparatus for a solar cell precursor of claim 25, **characterized in that,** the electroplating apparatus further comprises a circulating mechanism arranged on the electroplating tank and used for circulating the electroplating solution in the electroplating tank, the circulating mechanism comprises a second circulating assembly for realizing circulation of the electroplating solution from a lower portion of the electroplating tank to an upper portion of the electroplating tank, and/or a third circulating assembly for realizing circulation of the electroplating solution from an upper portion of the electroplating tank to a lower portion of the electroplating tank, and/or a first circulating assembly for realizing circulation of the electroplating solution in a lower portion of the electroplating tank.

35. The electroplating apparatus for a solar cell precursor of claim 25, **characterized in that,** the electroplating tank comprises an electroplating reaction tank body and a circulating replenishment tank body stacked on each other, and the electroplating reaction tank body is capable of being arranged to overflow unidirectionally to the circulating replenishment tank body.

36. A conductive piece for electroplating a solar cell precursor, **characterized in that,** the conductive piece is a flexible conductive structure, and configured to be a connecting element for electrically connecting the solar cell precursor to be electroplated with a negative electrode of a power supply for electroplating.

37. The conductive piece of claim 36, **characterized in that,** at least a partial area of the conductive piece has adhesion, and the conductive piece is capable of being bonded to an exposed conductive material layer on the solar cell precursor to be electroplated or to an area adjacent to the exposed conductive material layer on the solar cell precursor.
